Europäisches Patentamt

European Patent Office

Office européen des brevets

(11) Veröffentlichungsnummer: **0 089 639**

A2

(12) **EUROPÄISCHE PATENTANMELDUNG**

(21) Anmeldenummer: **83102696.8**

(22) Anmeldetag: **18.03.83**

(51) Int. Cl.³: **H 03 G 5/00**

(30) Priorität: **23.03.82 DE 3210574**

(43) Veröffentlichungstag der Anmeldung:
**28.09.83 Patentblatt 83/39**

(84) Benannte Vertragsstaaten:
**AT GB IT**

(71) Anmelder: **Firma Egon Engl**
**Trostberger Strasse 14**
**D-8261 Kay(DE)**

(72) Erfinder: **Engl, Edmund**
**Kastanienallee 4**
**D-8221 Waging(DE)**

(74) Vertreter: **Flach, Dieter Rolf Paul, Dipl.-Phys. et al,**
**Patentanwälte Andrae-Flach-Haug Max-Josefs-Platz 6/III**
**D-8200 Rosenheim(DE)**

(54) Elektronisches Gerät, insbesondere zum Einsatz für Verstärkeranlagen für Musikinstrumente.

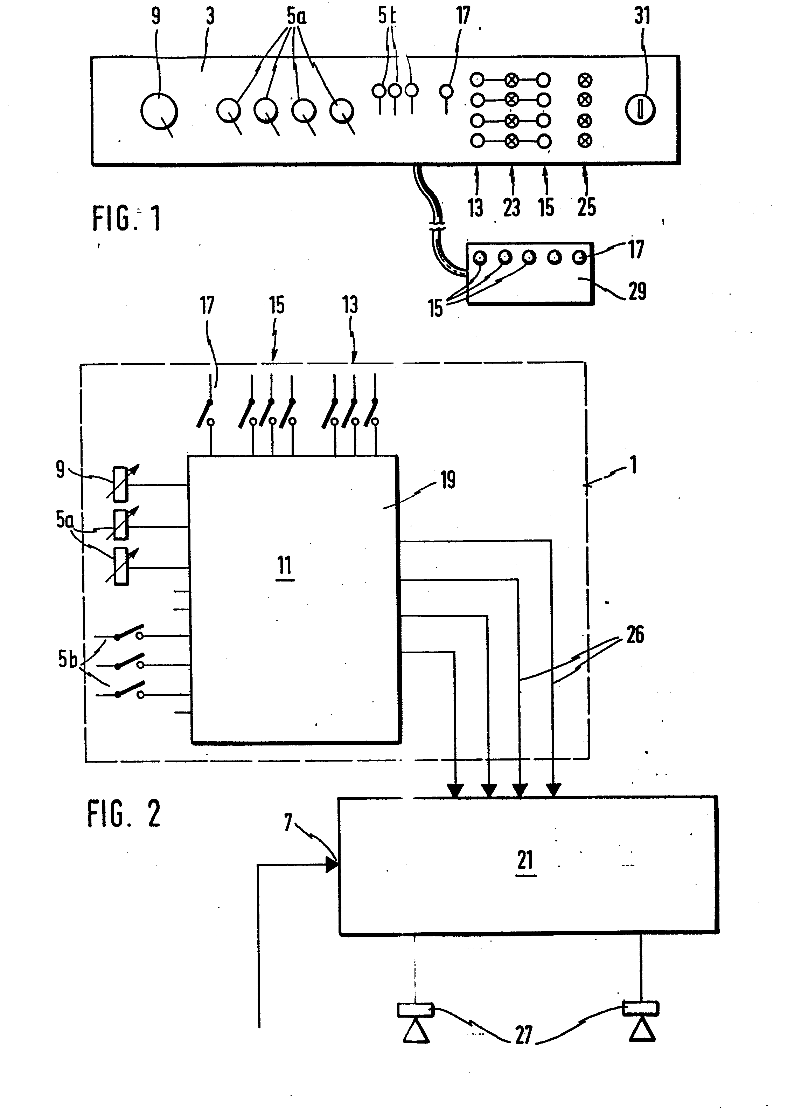

(57) Ein elektronisches Gerät insbesondere zum Einsatz für Verstärkeranlagen für Musikinstrumente umfaßt zahlreiche Einstellregler, durch deren Betätigung die Klangcharakteristik eines oder mehrerer angeschlossener Musikinstrumente im gewünschten Sinne geändert werden kann. Um die Vielfalt der Einstellmöglichkeiten voll auszunützen und um insbesondere auch während eines Liedstückes die Klangeffekte beliebig oft und schnell im gewünschten Sinne verändern zu können, ist ein Speicher (11) vorgesehen, in dem gewünschte und über die Einstellregler (5) eingestellte Werte abspeicherbar und wieder abrufbar sind (Fig. 2).

FIG. 2

EP 0 089 639 A2

PATENTANWÄLTE

# ANDRAE · FLACH · HAUG 0089639

### EUROPEAN PATENT ATTORNEYS

Patentanwalt Dipl.-Phys. Flach, Max-Josefs-Platz 6, D-8200 Rosenheim .

**ROSENHEIM**
Dipl.-Phys. Dieter Flach
Max-Josefs-Platz 6
D-8200 Rosenheim
Telefon: (0 80 31) 1 93 52
Telegramm: Physicist Rosenheim

**MÜNCHEN**
Dipl.-Chem. Dr. Steffen Andrae
Dipl.-Ing. Dietmar Haug
Steinstraße 44
D-8000 München 80
Telefon: (0 89) 48 20 89
Telegramm: pagema München
Telex: 5 216 281 afho d

Firma Egon Engl, Trostberger Str. 14, 8261 Kay


302 P 3

_____


## Elektronisches Gerät, insbesondere zum Einsatz für Verstärkeranlagen für Musikinstrumente

_____


Die Erfindung betrifft ein elektronisches Gerät insbesondere zum Einsatz für Verstärkeranlagen für Musikinstrumente nach dem Oberbegriff des Anspruches 1.

Bei heutzutage eingesetzten Musikinstrumenten ist es bekannt, den Klangcharakter über einen nachgeschalteten Verstärker in gewünschter Weise zu verändern und einzustellen. Dabei werden in bekannter Weise die Schwingungen der Musikinstrumente, gleichgültig ob es sich dabei beispielsweise um Konzertgitarren, Blasinstrumente etc. handelt, über Tonabnehmer aufgenommen und an einen nachgeordneten Verstärker gegeben.

Das gleiche gilt auch bei der Aufnahme von menschlichen Stimmen, wobei die elektromagnetischen Schwingungen über das Mikrophon über den Verstärker weitergegeben werden. Bei dem Verstärker kann es sich jeweils um Einzelverstärker, aber auch um einen Gesamtverstärker für alle vorgesehenen Musikinstrumente handeln, wobei am Ausgang ein entsprechendes elektrisches Mischsignal über die elektroakustische Wiedergabeeinrichtung in Form von Lautsprechern abgegeben wird.

Bei diesen Verstärkern ist es auch bekannt, die Klangcharakteristik in weiten Bereichen beliebig einzustellen. Dazu sind bei bekannten Verstärkern neben einer Lautstärkeregelung auch Regeleingänge vorgesehen, die eine Beeinflussung des verstärkten Signales und damit der Wiedergabe, beispielsweise zur Erzielung von Hall- oder Tremoloeffekten oder zur Änderung der Klangfarbe gestatten. Diese technischen Möglichkeiten zur Beeinflussung des Klangbildes haben dem Spieler die Komposition völlig neuartiger Klangbilder eröffnet, was insbesondere auch zu einer starken Beeinflussung und Veränderung der zeitgenössischen Musik geführt hat.

Aufgabe der Erfindung ist es, die Möglichkeit des Spielers zur Beeinflussung der gesamten Klangcharakteristik gegenüber dem Stand der Technik weiter zu erhöhen, sodaß insbesondere auch während eines Musikstückes unterschiedlichste Klangcharakteristiken erzeugt und umgesetzt werden können.

Die Aufgabe wird erfindungsgemäß entsprechend den im kennzeichnenden Teil des Anspruches 1 angegebenen Merkmale gelöst. Vorteilhafte Ausgestaltungen der Erfindung im Sinne der Aufgabenstellung sind in den Unteransprüchen angegeben.

Durch die vorliegende Erfindung wird erstmals ein elektronisches Gerät geschaffen, mittels dem der Spieler die unterschiedlichsten Hall- oder Tremoloeffekte, die Lautstärke, die Klangregelung, also auch die Klangfarbe etc., aber auch beispielsweise die Ausschallung eines Raumes mittels eines dafür vorgesehenen Equalizers beliebig fest einstellen kann, und vor allem auch während eines Liedes beliebig häufig die unterschiedlichsten Klangcharakteristiken abrufen und aktivieren kann. Dadurch wird die Variationsmöglichkeit deutlich erhöht. So können gemäß der Erfindung die unterschiedlichsten Klangbilder getestet und dann die entsprechende Einstellung der Einstellregler abgespeichert werden. Während der Aufführung können dann während eines Musikstückes die unterschiedlichen abgespeicherten Einstell- und Regelwerte abgerufen werden, sodaß die dadurch voreingestellten Hall- und Tremoloeffekte, die Klangfarbe etc. insbesondere während eines Musikstückes beliebig umgesetzt werden können.

Als besonders vorteilhaft erweist sich darüber hinaus, daß beim Aufbau der Anlagen in verschiedenen Konzertsälen jeweils die optimale Einstellung für die unterschiedlichsten Stücke festgestellt und festgehalten, und dann an beliebiger Stelle während des Spielens wieder abgerufen werden können.

In einer bevorzugten Ausführungsform der Erfindung nach Anspruch 2 ist zusätzlich ein Ist-Schalter vorgesehen, über den die aktuelle Einstellung der Einstellregler unter Umgehung des Speichers unmittelbar an dem Ausgang des elektronischen Gerätes anliegt. Zum einen ist dadurch sichergestellt, daß jeweils aktuell die Klangregelung unabhängig von den eingespeicherten Werten vorgenommen werden kann. Zum anderen wird dadurch quasi bei der Umschaltung ein zusätzlicher "Speicherplatz" geschaffen, da somit sowohl die gespeicherten wie auch der aktuell eingestellte Einstellregelwert beliebig abgerufen und die entsprechenden Werte an den Ausgang gelegt werden können.

In einer Weiterbildung der Erfindung nach Anspruch 3 sind zwischen den Einstellreglern, die in analoger Weise arbeiten, und dem nachgeordneten Speicher jeweils ein Analog-Digitalwandler zugeordnet. Dadurch lassen sich in optimaler und einfacher Weise die eingestellten Regelwerte in einem Digitalspeicher abspeichern.

In entsprechender Weise sind dem Speicher Digital-Analogwandler nachgeordnet, sodaß die digitalisierten Regelwerten wieder in analoge Signale zur Steuerung eines nachgeordneten Verstärkers umgesetzt werden können.

In einer bevorzugten Ausführungsform nach Anspruch 5 sind neben den Einstellreglern zur Beeinflussung der Klangfarbe und Lautstärke etc. zumindest ein weiterer, nicht abspeicherbarer Einstellregler, insbesondere für die Lautstärkeregelung vorgesehen. Dadurch lassen sich auch spezielle musikalische Effekte erzielen, wenn nämlich beispielsweise der speicherbare Lautstärkeregler, ein sogenannter Master-Regler auf große Werte eingestellt wird, während der nicht speicherbare Lautstärkeregler auf die übliche Lautstärke eingestellt wird. Dadurch kommt es zu speziellen Verzerrungseffekten, wodurch eine zusätzliche Variationsmöglichkeit zur Beeinflussung des Klangbildes geschaffen wird.

In einer Weiterbildung der Erfindung nach Anspruch 6 ist ein nullspannungsgesicherter Speicher vorgesehen. Dadurch ist es möglich, daß auch einmal eingespeicherte Einstell- und Regelwerte auch nach Abschalten und Abbauen des Verstärkers abgespeichert bleiben und beim Wiederaufbau an einem anderen Ort erneut ohne neues langwieriges Einregeln abgerufen werden können.

In einer bevorzugten und vorteilhaften Ausführungsform der Erfindung nach Anspruch 7 ist eine Anzeigevorrichtung vorgesehen, die den jeweils aktuell angesteuerten Speicherplatz anzeigt. Über eine weitere Anzeigeeinrichtung gemäß Anspruch 8 kann darüber hinaus angezeigt werden, welche Speicherplätze bereits besetzt sind, um ein versehentliches Löschen gespeicherter Werte zu verhindern.

In vorteilhafter Weise sind die Speicherabruftasten nach Anspruch 9 in Form eines Fußschalters
ausgebildet. Aufgrund dieser Ausbildung wird es
dem Spieler in besonders günstiger Weise ermöglicht, während eines Musikstückes auf einfachste
Art und Weise die unterschiedlichen gespeicherten
Klangcharakteristiken abzurufen, um das Klangbild
des gespielten Musikinstrumentes bzw. das Klangbild der über ein Mikrophon aufgenommenen menschlichen Stimme beliebig oft in der gewünschten Weise
zu verändern.

In einer Weiterbildung der Erfindung nach Anspruch
10 ist eine mechanische und/oder elektrische Verriegelungseinrichtung vorgesehen, über die sichergestellt werden kann, daß von unbefugter Seite
weder bewußt noch aus Versehen die abgespeicherten
Werte gelöscht werden können.

Nach Anspruch 12 wird erfindungsgemäß ein Verstärker vorgeschlagen, der ein elektronisches Gerät
nach einem der Ansprüche 1 bis 12 mitumfaßt. Dadurch
wird eine kompakte Gesamtverstärkeranlage mit all
den erfindungsgemäßen Vorteilen verwirklicht..

Nachfolgend wird die Erfindung anhand von Zeichnungen an einem Ausführungsbeispiel näher erläutert.
Dabei zeigen im einzelnen:

Figur 1 :    eine Frontansicht eines erfindungsgemäßen
             elektronischen Gerätes;

Figur 2 :    ein Schemaplan des erfindungsgemäßen
             elektronischen Gerätes.

In Fig. 1 und 2 ist ein elektronisches Gerät mit 1 mit einer Front- und Einstellplatte 3 mit zahlreichen Einstellreglern 5 gezeigt. Über die Einstellregler 5, die beispielsweise aus Potentiometern 5a und aus Ein- und Ausschaltern 5b bestehen können, wird die Klangregelung der elektromagnetischen Schwingungen, vor-genommen, die über eine nicht näher gezeigte Tonabnehmereinrichtung von einem Musikinstrument abgenommen und an einen Eingang 7 gelegt werden. Über die Einstellregler 5 können beispielsweise Hall- oder Tremoloeffekte, die Klangfarbe, Verzerreffekte, oder aber auch für verschiedene Musikinstrumente ein bestimmter Lautstärkerabstand eingeregelt werden. Eben desweiteren lassen sich dadurch gewisse Musikeffekte beispielsweise durch eine bestimmte Phasenverschiebung etc. aussteuern.

Mit 9 ist ein nicht speicherbarer Regler, insbesondere für die Lautstärkeregelung vorgesehen.

Mit 11 ist ein nullspannungsgesicherter Speicher bezeichnet, in dem die an den Einstellreglern 5 eingestellten Werte abgespeichert werden können. Darüber hinaus sind Speichereingabetasten 13 und Speicherabruftasten 15 vorgesehen. Weiterhin ist mit 17 ein Ist-Schalter bezeichnet, bei dessen Betätigung die bei den Einstellreglern 5 eingestellten Werte unmittelbar am Ausgang 19 anliegen, der mit einem Verstärker 21 verbunden ist.

Darüber hinaus ist eine Anzeigeeinrichtung 23 vorgesehen, die zur Anzeige des jeweils adressierten Speicherplatzes und eine Anzeigeeinrichtung 25 vorgesehen, die zur Anzeige des jeweils besetzten Speicherplatzes dient.

Nachfolgend wird die Funktionsweise des elektronischen Gerätes 1 näher erläutert.

Über den Eingang 7 sind ein oder mehrere Musikinstrumente angeschlossen. Die dem Eingang 7 zugeführten elektromagnetischen Schwingungen der Musikinstrumente werden durch Betätigung der Einstellregler 5 so beeinflußt, daß die gewünschten Klangbilder erzeugt werden können. Die entsprechenden Signale liegen am Ausgang 19 an und werden über Leitungen 26 dem nachgeordneten Verstärker 21 zugeführt, sodaß die entsprechend modifizierten elektrischen Schwingungen über Lautsprecher 27 akustisch wiedergegeben werden.

Entsprechen das Klangbild und die Klangeffekte den Vorstellungen des Spielers, so können die aktuell eingestellten Regelwerte durch Betätigung einer ersten Speichereingabetaste 13 in dem Speicher 11 abgespeichert werden. D. h. daß bei Betätigung der Speichereingabetaste 13 die aktuell an allen Einstellreglern 5 eingestellten Werte in einem entsprechenden Speicherplatz abgespeichert werden.

Danach können entsprechend den Vorstellungen des Spielers andere Werte über die Einstellregler 5 eingestellt und durch Betätigung einer nächsten Speichereingabetaste 13 ebenfalls abgespeichert werden. Über die Anzeigeeinrichtung 25, die beispielsweise aus Leuchtdioden. _ bestehen kann, wird jeweils angezeigt, welche Speicherplätze bereits besetzt sind.

In dem gezeigten Ausführungsbeispiel sind vier Speicherplätze gezeigt, um vier unterschiedliche Einstellungen der Einstellregler 5 abzuspeichern. Natürlich können aber entsprechend den Anfordernissen beliebig viele Speicherplätze vorgesehen sein.

Soll während des Spielens die Klangcharakteristik entsprechend den eingestellten Werten geändert werden, so braucht dafür lediglich eine der Speicherabruftasten 15 gedrückt zu werden, um die entsprechend abgespeicherten Werte abzurufen und die entsprechend modifizierten elektrischen Schwingungen der Musikinstrumente am Ausgang 19 des elektronischen Gerätes 1 zu erzeugen und am Ausgang 19 anzulegen. Dabei zeigt die Anzeigeeinrichtung 15, beispielsweise ebenfalls in Form einer Leuchtdiodenanzeige an, welche Speichereinstellung augenblicklich abgerufen wird.

Darüber hinaus wird durch Betätigung des Ist-Schalters 17 sichergestellt, daß das Klangbild entsprechend den aktuell eingestellten Werten an den Einstellreglern 5 modifiziert wird.

Da die Einstellung des Lautstärkereglers 9 dort nicht abspeicherbar ist, kann unabhängig von den abgespeicherten Werten eine entsprechend gewünschte Lautstärkeregelung vorgenommen werden.

Um während des Spielens einen Wechsel in der Klangcharakteristik für den Spieler möglichst einfach sicherzustellen, ist zusätzlich ein Fußschalter 29 vorgesehen, über den der Spieler ebenso wie über den Handschalter eine gewünschte Speicherabruftaste betätigen kann. Zur besseren Erkennbarkeit
können hier zusätzliche Lampen vorgesehen sein,
die den aktuell adressierten Speicher anzeigen.

In dem gezeigten Ausführungsbeispiel werden
nullspannungsgesicherte Speicher verwendet. Dadurch können beim Abschalten des Gerätes die eingestellten Werte abgespeichert werden, sodaß auch
später die gewünschte Klangcharakteristik und die
Klangeffekte wieder neu abgerufen und reproduzierbar sind.

Darüber hinaus ist ein mechanisch und/oder elektrisches Verriegelungselement 31 vorgesehen, mit
Hilfe dessen die abgespeicherten Werte im Speicher
11 so gesichert werden können, daß von unbefugter
Seite eine Löschung der eingestellten und abgespeicherten Werte unmöglich ist. Darüber hinaus
kann, wie nicht näher gezeigt ist, noch zusätzlich
ein Verzögerungsglied vorgesehen sein, sodaß während
des Spielens bei einer kurzzeitigen fehlerhaften Betätigung einer Speichereingabetaste nicht sofort
die eingestellten Werte gelöscht und die neuen
eingetragen werden.

Um eine entsprechende Abspeicherung der an den Einstellreglern 5 eingestellten Werte sicherzustellen,
sind - wie nicht näher gezeigt wird - zwischen den
Einstellreglern 5, also den Potentiometern 5a und
dem Speicher 11 Analog-Digitalwandler vorgesehen.
Entsprechend sind im Speicher 11 Digital-Analogwandler nachgeordnet, um wieder eine entsprechende
Umwandlung des Signals vorzunehmen.

In dem gezeigten Ausführungsbeispiel ist neben dem Verstärker 21 das elektronische Gerät 1 als separate Baueinheit gezeigt. Genauso ist es aber möglich, den Verstärker und das elektronische Gerät als einheitliche Baueinheit auszubilden.

In einer nicht näher gezeigten alternativen Ausführungsform der Erfindung ist es auch möglich, daß nur eine einzige Speichereingabetaste 13 vorgesehen ist. Dabei erfolgt die Adressierung eines entsprechenden Speicherplatzes lediglich durch Betätigung einer Speicherabruftaste 15. Soll eine bestimmte Einstellung der Einstellregler 5 abgespeichert werden, so muß zusätzlich noch die einzig vorgesehene Speichereingabetaste 13 beispielsweise länger als drei Sekunden gedrückt werden, damit die Einspeicherung erfolgt. In diesen Fällen kann eine zusätzliche Kontrollampe vorgesehen sein, die bei Betätigung der entsprechenden Taste über 3 sec entsprechend dem vorgesehenen Zeitglied aufleuchtet und so die erfolgte neue Einspeicherung anzeigt.

Ebenso möglich ist aber auch, daß nur Speicherabruftasten 15 vorgesehen sind, die gleichzeitig auch als Speichereingabetasten dienen. So wird bei kurzzeitiger Betätigung der Speicherabruftaste 15 eine entsprechende Adressierung des Speichers vorgenommen und die dort abgespeicherten Werte zur Steuerung des Verstärkers 21 weitergegeben. Wird eine der Speicherabruftasten 15 länger als beispielsweise 3 sec betätigt, so werden die an den Einstellreglern anstehenden Werte auf dem entsprechenden Speicherblatt abgespeichert.

Darüber hinaus kann .in einer nicht näher gezeigten Abwandlung der Erfindung auf eine separate Anzeigeeinrichtung 25 zur Anzeige der jeweils besetzten Speicherplätze verzichtet und lediglich eine einzige Anzeigeeinrichtung 23 zur Anzeige des jeweils adressierten Speicherplatzes vorgesehen sein.

PATENTANWÄLTE

# ANDRAE · FLACH · HAUG 0089639

## EUROPEAN PATENT ATTORNEYS

· Patentanwalt Dipl.-Phys. Flach, Max-Josefs-Platz 6, D-8200 Rosenheim ·

**ROSENHEIM**
Dipl.-Phys. Dieter Flach
Max-Josefs-Platz 6
D-8200 Rosenheim
Telefon: (0 80 31) 1 93 52
Telegramm: Physicist Rosenheim

**MÜNCHEN**
Dipl.-Chem. Dr. Steffen Andrae
Dipl.-Ing. Dietmar Haug
Steinstraße 44
D-8000 München 80
Telefon: (0 89) 48 20 89
Telegramm: pagema München
Telex: 5 216 281 afho d

Firma Egon Engl, Trostberger Str. 14, 8261 Kay

302 P 3

---

Elektronisches Gerät, insbesondere zum Einsatz
für Verstärkeranlagen für Musikinstrumente

---

Patentansprüche:

1. Elektronisches Gerät insbesondere zum Einsatz
für Verstärkeranlagen für Musikinstrumente mit
Einstellreglern zur Einstellung unterschiedlicher
Klangparameter, gekennzeichnet durch

- einen Speicher (11) zur Abspeicherung
  der eingestellten Klangparameter,
- mindestens eine Speichereingabetaste
  (13) und
- mindestens eine Speicherabruftaste (15),
- wobei die am Ausgang (19) des elektronischen Gerätes (1) anstehenden
  Signale einem nachgeschalteten Verstärker (21) zuführbar sind.

2. Elektronisches Gerät nach Anspruch 1, dadurch gekennzeichnet, daß zusätzlich ein Ist-Schalter (17) vorgesehen ist, über den im betätigten Zustand die an den Einstellreglern (5) eingestellten Werte unmittelbar am Ausgang (19) anliegen.

3. Elektronisches Gerät nach Anspruch 1 oder 2, dadurch gekennzeichnet, daß zwischen den analogen Einstellreglern (Potentiometern 5a) und dem Speicher (11) Analog-Digitalwandler angeordnet sind.

4. Elektronisches Gerät nach einem der Ansprüche 1-3, dadurch gekennzeichnet, daß dem Speicher (11) Digital-Analogwandler nachgeordnet sind.

5. Elektronisches Gerät nach einem der Ansprüche 1-4, dadurch gekennzeichnet, daß neben den Einstellreglern (5) zum Einstellen und Einspeichern von unterschiedlichen Klangparameter zumindest ein weiterer nicht abspeicherbarer Einstellregler (Regler 9), insbesondere ein Lautstärkeregler vorgesehen ist.

6. Elektronisches Gerät nach einem der Ansprüche 1-5, gekennzeichnet durch einen nullspannungsgesicherten Speicher (11).

7. Elektronisches Gerät nach einem der Ansprüche 1-6, dadurch gekennzeichnet, daß eine Anzeigeeinrichtung (23) zur Anzeige des jeweils adressierten Speicherplatzes vorgesehen ist.

8. Elektronisches Gerät nach einem der Ansprüche 1-7, dadurch gekennzeichnet, daß eine Anzeigeeinrichtung (25) zur Anzeige der jeweils besetzten

302 P 3

Speicherplätze vorgesehen ist.

9. Elektronisches Gerät nach einem der Ansprüche 1-8, dadurch gekennzeichnet, daß die Speicherabruftasten (15) über einen Fußschalter (29) betätigbar sind.

10. Elektronisches Gerät nach einem der Ansprüche 1-9, dadurch gekennzeichnet, daß ein Verriegelungselement (31) zur mechanischen und/oder elektrischen Verriegelung der eingespeicherten Werte vorgesehen ist.

11. Elektronisches Gerät nach einem der Ansprüche 1-10, dadurch gekennzeichnet, daß ein Zeitglied vorgesehen ist, und eine Einspeicherung im Speicher (11) erst erfolgt, wenn eine Speichereingabetaste (13) länger als die durch das Zeitglied eingestellte Zeit betätigt wird.

12. Elektronisches Gerät nach einem der Ansprüche 1-10, dadurch gekennzeichnet, daß zur Adressierung des Speichers (11) nur Speicherabruftasten (15) vorgesehen sind, und eine Einspeicherung im Speicher (11) erst erfolgt, wenn gleichzeitig eine einzige Speichereingabetaste (13) länger als die durch ein vorgesehenes Zeitglied eingestellte Zeit betätigt wird.

13. Elektronisches Gerät nach einem der Ansprüche 1-10, dadurch gekennzeichnet, daß gemeinsame Speichereingabe- und Speicherabruftasten (15) vorgesehen sind, und eine Einspeicherung im Speicher (11) erst erfolgt, wenn eine der Speichereingabe-
und Speicherabruftasten (15) länger als die durch
ein vorgesehenes Zeitglied eingestellte Zeit betätigt wird.

14. Verstärker insbesondere für Musikinstrumente,
dadurch gekennzeichnet, daß der Verstärker (21)
ein elektronisches Gerät (1) nach einem der Ansprüche 1-11 umfaßt.

FIG. 1

FIG. 2

0089639